# Europäisches Patentamt

## European Patent Office

## Office européen des brevets

(19)

(11) Numéro de publication: **0 214 019**
**B1**

(12) # FASCICULE DE BREVET EUROPEEN

(45) Date de publication du fascicule du brevet:
**23.05.90**

(51) Int. Cl.⁵: **H05K 9/00**

(21) Numéro de dépôt: **86401726.4**

(22) Date de dépôt: **01.08.86**

(54) **Procédé de réalisation d'un dispositif d'obturation pour enceinte du type cage de Faraday, et dispositif d'obturation obtenu par ce procédé.**

(30) Priorité: **02.08.85 FR 8511883**

(43) Date de publication de la demande:
**11.03.87 Bulletin 87/11**

(45) Mention de la délivrance du brevet:
**23.05.90 Bulletin 90/21**

(84) Etats contractants désignés:
**DE GB IT NL**

(56) Documents cités:
**EP-A- 0 121 720**
**DE-C- 459 551**
**FR-A- 2 188 910**
**US-A- 3 013 103**

**JOURNAL OF SCIENTIFIC INSTRUMENTS,**
**vol. 32, novembre 1955, page 450, Londres, GB; A.**
**GRIDLEY: "A brush for cleaning decade switch**
**contacts"**

(73) Titulaire: **THOMSON-CSF, 51, Esplanade du Général de Gaulle, F-92800 Puteaux(FR)**

(72) Inventeur: **Bellot, Guy, THOMSON - CSF SCPI 19, avenue de Messine, F-75008 Paris(FR)**

(74) Mandataire: **Courtellemont, Alain et al, THOMSON-CSF SCPI, F-92045 PARIS LA DEFENSE CEDEX 67(FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

## Description

La présente invention se rapporte à un procédé de réalisation d'un dispositif d'obturation, électromagnétiquement étanche, pour enceinte du type cage de Faraday ; l'invention s'applique plus particulièrement au cas où d'une part le dispositif d'obturation comporte un panneau destiné à obturer un orifice pratiqué dans la paroi extérieure d'une enceinte et où d'autre part il n'est que très exceptionnellement nécessaire de pouvoir passer à travers l'orifice, comme, par exemple, avec un orifice destiné à permettre une visite technique d'un matériel placé dans l'enceinte.

Il est connu de réaliser de tels dispositifs d'obturation en disposant un joint électromagnétiquement étanche entre la paroi de l'enceinte et le panneau, de manière qu'il forme une bande fermée sur elle-même et qui entoure l'orifice. De tels dispositifs d'obturation sont relativement couteux et, surtout, posent des problèmes d'approvisionnement lorsque, après quelques ouvertures du panneau, la déformation des joints nécessite leur changement.

La présente invention a pour but d'éviter ou, pour le moins, de réduire les inconvénients précités.

Ceci est obtenu en effectuant un traitement de surface au niveau des surfaces de contact entre l'enceinte proprement dite et le panneau.

Selon l'invention un procédé de réalisation d'un dispositif d'obturation pour enceinte du type cage de Faraday, ce dispositif comportant un panneau présentant une première surface de contact destinée à recouvrir, sur la paroi extérieure de l'enceinte, une seconde surface de contact, et la surface de contact de la paroi extérieure formant une bande fermée entourant un orifice d'accès à l'intérieur de l'enceinte, est caractérisé en ce qu'il consiste à employer une brosse à poils métalliques, à enduire les poils de la brosse d'un corps gras, chimiquement neutre et à effectuer un brossage des deux surfaces de contact au moyen de la brosse.

La présente invention, qui s'applique également au dispositif d'obturation obtenu selon ce procédé, sera mieux comprise et d'autres caractéristiques apparaîtront à l'aide de la description ci-après et des figures s'y rapportant qui représentent :

- la figure 1, un dispositif d'obturation selon l'invention,
- la figure 2, des moyens de mise en oeuvre du procédé selon l'invention,
- les figures 3 et 4 des illustrations de la mise en oeuvre du procédé selon l'invention.

Sur les différentes figures les éléments correspondants sont désignés par les mêmes repères.

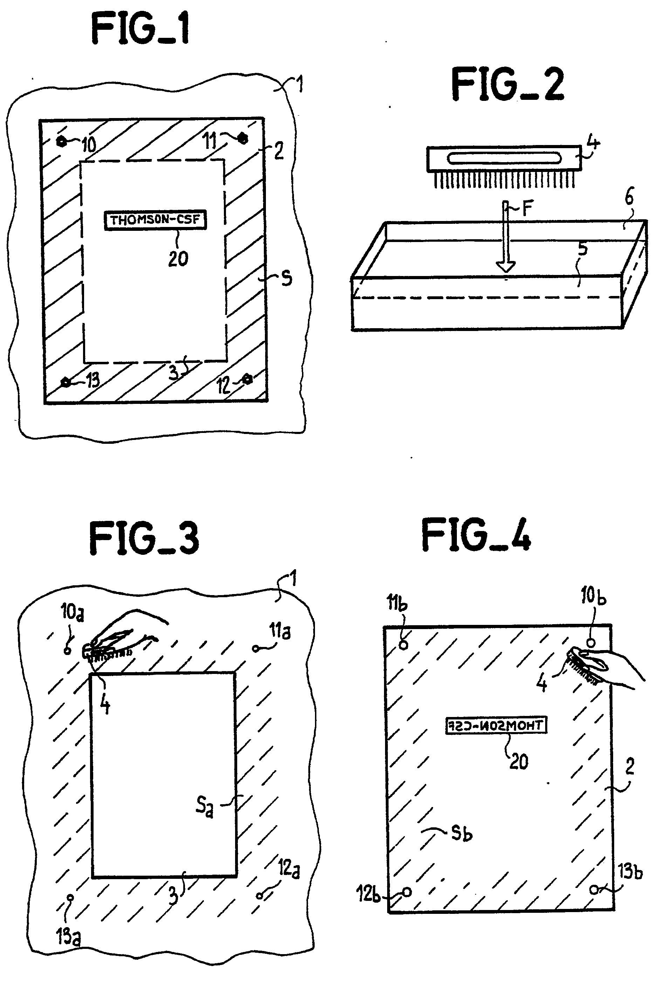

La figure 1 représente, en arraché, une partie de la paroi extérieure d'une enceinte, 1, du type cage de Faraday munie d'un dispositif d'obturation. Cette enceinte est percée d'un orifice rectangulaire, 3, recouvert par un panneau rectangulaire, 2, plus grand que l'orifice, et sur lequel a été apposée une plaque de constructeur, 20. Des ensembles tige filetée-écrou, 10, 11, 12, 13, dont les tiges filetées sont fixées sur l'enceinte perpendiculairement à la paroi de l'enceinte, assurent le positionnement et le blocage du panneau 2 sur la paroi de l'enceinte.

Sur la figure 1 les bords de l'orifice 3 ont été représentés en traits interrompus, comme s'ils étaient vus par transparence à travers le panneau 2. La zone S, où se fait le contact entre la paroi extérieure de l'enceinte 1 et le panneau 2, est indiquée par des hachures également vues par transparence à travers le panneau 2.

La figure 2 représente des moyens employés pour la mise en oeuvre d'un procédé permettant de rendre électromagnétiquement étanche le dispositif d'obturation de l'orifice 3, tel qu'il est représenté sur la figure 1. Il s'agit d'une brosse 4 à poils métalliques et d'un bac, 6, contenant un corps gras chimiquement neutre, 5, dans lequel sont plongés (flèche F) les poils de la brosse afin de les enduire de ce corps gras.

Après que la brosse 4 ait été trempée dans le bac 6, elle est employée pour effectuer un brossage des surfaces du panneau 2 et de la paroi extérieure de l'enceinte 1 qui viennent en contact suivant la zone S de la figure 1 ; c'est ce qui est représenté sur les figures 3 et 4.

La figure 3 représente le brossage de la surface de contact qui correspond, pour la paroi extérieure de l'enceinte 1, à la zone de contact S (figure 1) entre le panneau 2 et l'enceinte 1.

Sur la figure 3 apparaissent : l'orifice rectangulaire 3 et les tiges filetées 10a, 11a, 12a, 13a des ensembles tige filetée-écrou 10, 11, 12, 13 de la figure 1.

Le brossage de la zone Sa a été schématisé sur la figure 3 par le dessin de la brosse 4 tenue par une main.

La figure 4 représente le brossage de la surface de contact Sb qui correspond, pour l'arrière du panneau 2, à la zone de contact S (figure 1) entre le panneau 2 et l'enceinte 1.

Sur la figure 4 apparaissent : la plaque de constructeur, 20, comme si elle était vue par transparence et quatre trous 10b, 11b, 12b, 13b destinés à permettre le passage des tiges filetées 10a, 11a, 12a, 13a à travers le panneau.

Le brossage de la zone Sb a été schématisé sur la figure 4 par la brosse 4 tenue par une main.

Il est à remarquer que c'est pour rendre les dessins plus parlant que la brosse 4 a été représentée sous la forme d'une brosse à main ; mais, bien que le brossage manuel selon les figures 3 et 4 convienne, un brossage mécanique sera généralement préféré.

Le contrôle de la bonne exécution de la mise en oeuvre s'effectue une fois les deux faces de contact, préalablement graissées, appliquées l'une sur l'autre ; leur décollement ne doit pas laisser apparaître de marques sur les surfaces traitées.

Dans la réalisation qui a servi d'exemple pour la description ci-avant, la paroi de l'enceinte 1 et le panneau 2 étaient en aluminium, tandis que la brosse était une brosse à poils en acier inoxydale et que le corps gras chimiquement neutre 5 avait été préparé en mélangeant, dans de la vaseline, de fines particules constituées par des grains métalliques bons conducteurs de l'électricité.

L'invention n'est pas limitée à la réalisation qui vient d'être décrite, c'est ainsi, par exemple, que le corps gras, 5, aurait pu ne pas contenir de fines particules conductrices ; il aurait néanmoins fallu s'attendre alors à de moins bons résultats en ce qui concerne l'étanchéité électromagnétique du dispositif d'obturation selon la figure 1. De même, à l'aide d'une brosse à poils métalliques enduits d'un corps gras neutre, il est possible de rendre électromagnétique étanche un dispositif d'obturation où la matière des surfaces en contact est autre que l'aluminium ; mais les résultats les meilleurs sont obtenus lorsque les métaux sur lesquels est effectué le brossage sont relativement tendres, comme, par exemple, l'aluminium et les alliages à base d'aluminium.

Il est à noter qu'il est connu, pour faciliter le passage de forts courants entre deux surfaces en contacts, par exemple entre deux lames d'un commutateur, de procéder à un brossage, dit "brossage sous graisse", des surfaces destinées à venir en contact. Mais ce procédé n'avait, semble-t-il, jamais été appliqué au problème du passage des courants faibles et donc au problème consistant à rendre électromagnétiquement étanche un dispositif d'obturation pour enceinte du type cage de faraday; ceci est dû au fait que la technique des courants forts et celle des courants faibles sont deux techniques distinctes, voir opposées dans les buts à atteindre et les moyens à mettre en oeuvre, ce qui explique qu'il y avait une double barrière à l'application du "brossage sous graisse" à un problème de courants faibles : passer outre aux frontières relativement étanches entre les deux domaines techniques concernés afin d'envisager la possibilité d'utiliser le "brossage sous graisse" dans un problème de courants faibles et, ensuite, vaincre le préjugé qui consisterait à estimer que, de toutes façons, le "brossage sous graisse" ne peut être valable pour les courants faibles étant donné que c'est une technique qui relève des courants forts.

## Revendications

1. Procédé de réalisation d'un dispositif d'obturation pour enceinte (1) du type cage de Faraday, ce dispositif comportant un panneau (2) présentant une première surface de contact (Sb) destinée à recouvrir, sur la paroi extérieure de l'enceinte, une seconde surface de contact (Sa), et la surface de contact (Sa) de la paroi extérieure formant une bande fermée entourant un orifice (3) d'accès à l'intérieur de l'enceinte, caractérisé en ce qu'il consiste à employer une brosse (4) à poils métalliques, à enduire les poils de la brosse d'un corps gras (5), chimiquement neutre et à effectuer un brossage des deux surfaces de contact au moyen de la brosse.

2. Procédé selon la revendication 1, caractérisé en ce qu'il consiste à employer, comme corps gras (5), un mélange comportant une graisse neutre et de fines particules consistuées par des grains métalliques bons conducteurs de l'électricité.

3. Procédé selon la revendication 1, caractérisé en ce qu'il consiste à employer, comme brosse (4), une brosse dont les poils sont en acier inoxydable.

## Claims

1. A method for realizing a sealing device for an enclosure (1) of the Faraday cage type, this device comprising a panel (2) having a first contact surface (Sb) intended to cover a second contact surface (Sa) presented by the outer wall of said enclosure, this second contact surface (Sa) of the outer wall constituting a closed loop strip surrounding an access opening (3) to the inside of the enclosure, characterized in that a brush (4) having metallic bristles is used, that the brush bristles are treated with a grease material (5) which is chemically neutral, and that both contact surfaces are brushed by means of this brush.

2. A method according to claim 1, characterized in that the grease material (5) is a mixture comprising a neutral grease and fine particles constituted by metal grains presenting a high electric conductivity.

3. A method according to claim 1, characterized in that a brush (4) with bristles made of stainless steel is used.

## Patentansprüche

1. Verfahren zur Herstellung eines Verschlußorgans für einen Raum von der Art eines Faraday-Käfigs, wobei dieses Organ eine Platte (2) mit einer ersten Kontaktfläche (Sb) besitzt, die eine zweite Kontaktfläche (Sa) auf der Außenwand des Raums bedecken soll, und wobei diese Kontaktfläche (Sa) auf der Außenwand des Raums einen geschlossenen Streifen bildet, der die Zugangsöffnung (3) zum Inneren des Raums umgibt, dadurch gekennzeichnet, daß eine Bürste (4) mit Metallborsten verwendet wird, daß die Borsten mit einem chemisch neutralen Fettstoff (5) eingelassen werden und daß die beiden Kontaktflächen mit der Bürste behandelt werden.

2. Verfahren nach Anspruch 1, dadurch gekennzeichnet, daß als Fettstoff (5) eine Mischung aus einem neutralen Fett und aus feinen Partikeln verwendet wird, die aus elektrisch gut leitenden Metallkörnern bestehen.

3. Verfahren nach Anspruch 1, dadurch gekennzeichnet, daß eine Bürste (4) verwendet wird, deren Borsten aus rostfreiem Stahl bestehen.

# FIG_1

# FIG_2

THOMSON-CSF

20

1
10
11
2
S
13
3
12

4
F
6
5

# FIG_3

# FIG_4

1
10a
11a
4
Sa
12a
3
13a

11b
10b
4
THOMSON-CSF
20
2
Sb
12b
13b